# EUROPÄISCHE PATENTSCHRIFT

(11) **EP 1 636 651 B1**
(45) Veröffentlichungstag und Bekanntmachung des Hinweises auf die Patenterteilung: **28.10.2009**
(21) Anmeldenummer: 04738713.9
(22) Anmeldetag: 17.06.2004
(51) Int. Cl.: G03F 7/00, B29C 67/00

(54) **NIEDRIGVISKOSE,STRAHLUNGSHÄRTBARE FORMULIERUNG, INSBESONDERE FÜR DIE STEREOLITHOGRAPHISCHE HERSTELLUNG VON OHRSTÜCKEN**
LOW-VISCOUS, RADIATION CURABLE FORMULATION, PARTICULARLY FOR THE STEREOLITHOGRAPHICAL PRODUCTION OF EARPIECES
FORMULATION A FAIBLE VISCOSITE DURCISSABLE PAR RAYONNEMENT DESTINEE NOTAMMENT A LA PRODUCTION STEREOLITHOGRAPHIQUE D'ECOUTEURS

(30) Priorität: 23.06.2003 DE 10328302
(43) Veröffentlichungstag der Anmeldung: 22.03.2006
(73) Patentinhaber: Dreve Otoplastik Gmbh, 59423 Unna (DE)
(72) Erfinder: KLARE, Martin, 44137 Dortmund (DE); ALTMANN, Reiner, 44575 Castrop-Rauxel (DE); KUTSCHINSKI, Michael, 44579 Castrop-Rauxel (DE); MEISSNER, Georgia, 45731 Waltrop (DE); VEIT, Thomas, 48151 Münster (DE)
(74) Vertreter: Köchling, Conrad-Joachim
(86) Internationale Anmeldenummer: PCT/DE2004/001262
(87) Internationale Veröffentlichungsnummer: WO 2005/001570

(56) Entgegenhaltungen:
- EP-A- 0 425 441
- EP-A- 1 245 369
- EP-A- 1 385 055
- EP-B- 0 822 445
- WO-A-03/029365
- WO-A-03/099947

## Beschreibung

Die vorliegende Erfindung betrifft eine niedrigviskose, strahlungshärtbare Formulierung zur stereolithographischen Herstellung von medizintechnischen Produkten, insbesondere zur Herstellung von Ohrstücken, auf Basis mindestens zweier Verbindungen, die radikalisch polymerisierbare Methacrylatfunktionen aufweisen, und mindestens eines für die Polymerisation der geeigneten Verbindungen geeigneten Photoinitiators, und mindestens des einen für die Stabilisierung des Stereolithographieharzes bestimmten Inhibitors 2,2,6,6-Tetrametylpiperidin-1-yloxy (freies Radikal), der neben anderen schon in der Technik für Stereolithographieharze bekannten Inhibitoren als eine sehr vorteilhafte Formulierungskomponente für solchartige Zusammensetzungen geeignet ist.

Es ist aus US. Pat. 4,575,330 bekannt, dass niedrigviskose, strahlungshärtbare Harze bzw. Harzgemische für die Herstellung von dreidimensionalen Objekten mittels Stereolithographie eingesetzt werden können.

Ferner ist aus US. Pat. 5,487,012 und WO 01/87001 bekannt, dass die Stereolithographie vorteilhaft zur Herstellung von Ohrstücken eingesetzt werden kann. Beim stereolithographischen Verfahren werden dreidimensionale Objekte aus einer niedrigviskosen, strahlungshärtbaren Formulierung in der Weise aufgebaut, dass jeweils eine dünne Schicht (ca. 0,0025-0,01 mm) der Formulierung mittels aktinischer Strahlung in definierter Weise so vorhärtet, dass die erzeugte Schicht die gewünschte Querschnittsform des Objektes an dieser Stelle vorweist. Zeitgleich wird die erzeugte Schicht an die im Schritt zuvor gehärtete Schicht polymerisiert. Der Aufbau des Gesamtobjektes lässt sich so mit Hilfe eines computergesteuerten Lasersystems wie z. B. eines Nd:YVO₄ Festkörperlasers (Viper si² SLA System,Fa. 3D Systems, USA) bewerkstelligen. Der generierte Formkörper wird gegebenenfalls, z. B. durch Strahlenhärtung, nachgehärtet.

An die im stereolithographischen Prozess einsetzbaren Harzformulierungen werden besondere Anforderungen gestellt. Dabei sind insbesondere die Strahlungsempfindlichkeit und die Viskosität der Harzformulierungen, sowie die Festigkeit der mittels Laserhärtung vorgehärteten Formkörper zu nennen. Dieser nicht völlig gehärtete Formkörper wird in der Technik der Stereolithographie als Grünling bezeichnet, und die Festigkeit dieses Grünlings, charakterisiert durch den E-Modul und die Biegefestigkeit, bezeichnet man als Grünfestigkeit. Die Grünfestigkeit stellt für die Praxis der Stereolithographie einen wichtigen Parameter dar, da Formkörper mit geringer Grünfestigkeit sich während des Stereolithographieprozesses unter ihrem eigenen Gewicht deformieren können oder diese können während der Nachhärtung, beispielsweise mit einer Xenonbogen- oder Halogenlampe, absacken oder sich durchbiegen. Es ist daher verständlich, dass unter Berücksichtigung der oben genanten Anforderungen kompliziert abgestimmte und formulierte Zusammensetzungen eingesetzt werden.

Beispielsweise wird von H. Kodama in Rev. Sci. Instrum. 52 (11), 1170-1173 (1981) eine niedrigviskose, strahlungshärtbare Harzformulierung offenbart, die aus einem ungesättigten Polyester, einem Acrylsäureester, Styrol und einem Polymerisationsinitiator besteht. Im Hinblick auf den Einsatz in der Stereolithographietechnik weist diese Harzformulierung jedoch eine geringe Grünfestigkeit und eine ungenügende Photoempfindlichkeit auf.

Eine ebenfalls unter produktionstechnischen Gesichtspunkten ungenügende Photoempfindlichkeit weisen die in US. Pat. 4,100,141 offenbarten Harzformulierungen auf. Dabei bedeutet eine geringe Photoempfindlichkeit, dass lange Zeiten für die Herstellung der Formkörper benötigt werden. Dementsprechend muss die Photoempfindlichkeit der Stereolithographieharzformulierungen so eingestellt sein, dass sich aus dem Verhältnis von erzielter Eindringtiefe des Laserstrahles in die niedrigviskose, strahlungshärtbare Harzformulierung und der aufgewandten Strahlungsenergie ergibt, dass mit geringer Strahlungsenergie eine möglichst große Härtungstiefe bei gleichzeitig hohem Polymerisationsgrad, guter Grünfestigkeit und ausreichender Stabilität der Harzformulierung gegen Autopolymerisation realisiert werden. Flüssige, strahlungshärtbare Harzformulierungen die den o. g. Anforderungen teilweise genügen sind beispielsweise in US. Pat. 5,476,748 oder in WO 99/50711 beschrieben. Diese als "Hybrid-System" bezeichneten Formulierungen enthalten allerdings eine Kombination aus radikalisch und kationisch polymerisierbaren Komponenten. Sie bestehen erstens aus einer flüssigen, di- bzw. polyfunktionellen Epoxyverbindung oder aus einer Mischung, bestehend aus difunktionellen oder höherfunktionellen Epoxyverbindungen; zweitens aus einem kationischem Photoinitiator bzw. aus einer Mischung von kationischen Photoinitiatoren; drittens aus einem Photoinitiator bzw. aus einer Mischung von Photoinitiatoren für die freie radikalische Polymerisation und mindestens aus einem niedrigviskosen Poly(meth)acrylat mit einer (Meth)acrylatfunktionalität von n>2, mindestens einem Diacrylat und einer Polyolkomponente aus der Gruppe hydroxylterminierter Polyether, Polyester und Polyurethane. Dem Fachmann ist bekannt, dass solche Formulierungen unter toxikologischen Aspekten kritisch zu bewerten sind und demzufolge nicht oder nur eingeschränkt zur Herstellung von Medizinprodukten eingesetzt werden können. Beispielsweise ist bekannt, dass kationische Photoinitiatoren zu Hautreizungen und allergischen Reaktionen führen können. Ähnliches gilt für die in solchen Formulierungen eingesetzten Verbindungen mit Epoxidfunktionen. Es ist dem Fachmann ferner bekannt, dass Acrylatverbindungen ebenfalls ein erhöhtes Allergiepotential besitzen und somit Harzzusammensetzungen, wie sie z. b. in EP 0425441, EP 0914242 und EP 0579503 beschrieben sind, unter Biokompatibilitätsaspekten nicht zur Herstellung von z. b. Ohrstücken verwendet werden können. Für den Einsatz in der Medizintechnik haben sich monomere oder oligomere Dimethacrylate auf Basis von Bisphenol A oder Bisphenol F und Urethanmethacrylate mit einer Funktionalität von n ≥ 2 bewährt. Im Vergleich zur Gruppe der Acrylatverbindungen weist für die Technik der Stereolithographie die Gruppe der Methacrylatverbindungen jedoch eine geringere Reaktivität auf. Daraus ergeben sich die schon o. g. Nachteile hinsichtlich Eindringtiefe des Laserstrahles und Grünfestigkeit der vorgehärteten Objekte. Infolge der geringeren Reaktivität dieser Verbindungsklasse ist es ferner notwendig, höhere Konzentrationen an einem oder mehreren Photoinitiatoren für die freie radikalische Polymerisation einzusetzen. Dies führt zu einer verringerten Stabilität gegen Autopolymerisation der Harzzusammensetzungen. Dem Fachmann ist weiterhin bekannt, dass in der Technik der Stereolithographie bei der Herstellung einer großen Anzahl kleinteiliger Objekte von geringer Masse eine erhöhte mechanische und thermische Belastung der Stereolithographieharzformulierung vorliegt, die zu einer Autopolymerisation des Stereolithographieharzes bzw. zu sich verändernden Eigenschaften der Harzzusammensetzung und der daraus generierten Formkörper führen kann. Dies ist zum einen darauf zurückzuführen, dass bei geringem Harzverbrauch die auf einer Plattform fixierten, vorgehärteten Formkörper relativ häufig aus dem Bauraum der Stereolithographieanlage entfernt werden müssen. Daraus resultieren Temperaturschwankungen des Stereolithographieharzes im Bauraum. Zum anderen ergibt sich bei der Produktion von Ohrstücken ein relativ großes Oberflächen- zu Volumenverhältnis der generierten Formkörper. Es ist dem Fachmann bekannt, dass bei der freien radikalischen Polymerisation infolge von Sauerstoffzutritt eine Inhibierungsschicht an der Oberfläche der Formkörper zurückbleibt. Das nur unvollständig an- bzw. auspolymerisierte Harz kann sich so während des Bauprozesses von der Oberfläche des Probenkörpers in das Stereolithographieharz lösen.

Aus diesen Punkten ist ersichtlich, dass bei der Herstellung von Ohrstücken mittels der stereolithographischen Technik die Stabilisierung der niedrigviskosen, strahlungshärtbaren Harzzusammensetzung ein bedeutender Parameter ist. Unter produktionstechnischen Gesichtspunkten ist es daher wünschenswert, dass bei möglichst konstanter Eindringtiefe des Laserstrahles die kritische Energie der Stereolithographieharzformulierung der Anwendung entsprechend eingestellt werden kann.

Aufgabe der vorliegenden Erfindung ist es, eine Stereolithographieharzformulierung für die Produktion von Medizinprodukten, insbesondere von Ohrstücken, zur Verfügung zu stellen, die sowohl die mechanischen, toxikologischen als auch die an das Rapid Manufacturing mittels Stereolithographie gestellten Anforderungen erfüllt. Es wurde nun gefunden, dass ein niedrigviskoses, aus einem oder mehreren voneinander verschiedenen monomeren oder oligomeren Dimethacrylaten auf Basis von Bisphenol A oder Bisphenol F bestehendes Harzgemisch, das außerdem ein Urethanmethacrylat mit einer Funktionalität von n < 4 und einer Viskosität < 10 Pa s, weiterhin ein monomeres aliphatisches oder cycloaliphatisches Dimethacrylat mit einer Viskosität < 3 Pa s und das 2,2,6,6-Tetramethylpiperidin-1-yloxy (freies Radikal) enthält, für die Technik der Stereolithographie eingesetzt werden kann und das bei der Härtung mittels Lasers vorgehärtete Formkörper ergibt, die sich durch eine hohe Grünfestigkeit auszeichnen. Überraschenderweise wurde weiter gefunden, dass mit dem Inhibitor 2,2,6,6-Tetramethylpiperidin-1-yloxy (freies Radikal) strahlungshärtbare, niedrigviskose Stereolithographieharzformulierungen herstellbar sind, deren Verhältnis von kritischer Energie zur Eindringtiefe des Laserstrahles in weiten Bereichen eingestellt werden können. Die durch Aushärtung erhaltenen Formkörper weisen neben guten mechanischen Eigenschaften exzellente Biokompatibilität auf, sind hartelastisch und können nachbehandelt wie beispielsweise geschliffen oder lackiert werden.

Der Gegenstand der vorliegenden Erfindung ist dementsprechend ein niedrigviskoses, strahlungshärtbares Stereolithographieharz, enthaltend
a) 55-95 Ges.-% eines monomeren oder oligomeren Dimethacrylats auf Basis von Bisphenol A oder Bisphenol F
b) 0-20 Gew.-% eines Urethanmethacrylats mit einer Funktionalität von n < 4 und einer Viskosität < 10 Pa s
c) 2-15 Gew.-% eines monomeren aliphatischen oder cycloaliphatischen Dimethacrylats mit einer Viskosität < 3 Pa s
d) 0-15 Gew.-% eines monofunktionellen Methacrylats mit einer Viskosität < 3 Pa s
e) 0,5-6 Ges.-% eines oder einer Kombination mehrerer Photoinitiatoren, deren Absorption im Wellenlängenbereich des eingesetzten Laserstrahles liegt
f) 0,0001-2 Gew.-% des Inhibitors 2,2,6,6-Tetramethylpiperidin-1-yloxy (freies Radikal), auch in Verbindung mit denen, dem Stereolithographiefachmann bekannten Inhibitoren
g) 0-40 Gew.-% an Füllstoffen
h) 0-5 Ges.-% an Farbpigmenten
i) 0-5 Gew.-% an üblichen Additiven wie UV-Stabilisatoren oder Verlaufsadditiven, wobei der Anteil der Komponenten a) bis h) zusammen 100 Gew.-% beträgt.

Vorzugsweise enthält das erfindungsgemäße Gemisch
a) 60-90 Ges.-% eines n-fach ethoxylierten Bisphenol-A-Dimethacrylats mit einem Ethoxylierungsgrad von n < 10 oder eine Mischung n-fach ethoxylierter Bisphenol-A-Dimethacrylate mit einem Ethoxylierungsgrad von n < 10
b) 5-17 Gew.-% eines aliphatischen oder cycloaliphatischen Urethanmethacrylats mit einer Funktionalität von n < 4 und einer Viskosität < 10 Pa s
c) 3-10 Gew.-% eines monomeren aliphatischen oder cycloaliphatischen Dimethacrylats mit einer Viskosität < 3 Pa s
d) 2-10 Gew.-% eines monofunktionellen Methacrylats mit einer Viskosität < 3 Pa s
e) 1-4 Gew.-% eines oder einer Kombination mehrere Photoinitiatoren, deren Absorption im Wellenlängenbereich des eingesetzten Laserstrahles liegt
f) 0,005-0,05 Gew.-% des Inhibitors 2,2,6,6-Tetramethylpiperidin-1-yloxy (freies Radikal), auch in Verbindung mit denen, dem Stereolithographiefachmann bekannten Inhibitoren
g) 0-20 Gew.-% an Füllstoffen
h) 0-5 Gew.-% an Farbpigmenten
i) 0,01-3 Ges.-% an üblichen Additiven wie UV-Stabilisatoren oder Verlaufsadditiven, wobei der Anteil der Komponenten a) bis h) zusammen 100 Gew.-% beträgt.

Als Verbindungen der Komponente (a) eignen sich beispielsweise Dimethacrylate des (n)-alkoxyliertem Bisphenol A wie Bisphenol-A-ethoxylat(2)dimethacrylat, Bisphenol-A-ethoxylat(4)dimethacrylat, Bisphenol-A-propoxylat(2)dimethacrylat, Bisphenol-A-propoxylat(4)dimethacrylat sowie Dimethacrylate des (n)-alkoxylierten Bisphenol F wie Bisphenol-F-ethoxylat(2)dimethacrylat und Bisphenol-F-ethoxylat(4)dimethacrylat , Bisphenol-F-propoxylat(2)dimethacrylat, Bisphenol-F-propoxylat(4)dimethacrylat und Mischungen dieser. Vorzugsweise verwendet man monomere oder oligomere Dimethacrylate auf Basis von Bisphenol A, insbesondere das Bisphenol-A-ethoxylat(2)dimethacrylat und das Bisphenol-A-ethoxylat(4)dimethacrylat. Besonders bevorzugt sind dabei Mischungen dieser beiden Dimethacrylate auf Bisphenol-A-Basis, mit einem Anteil an Bisphenol-A-ethoxylat(4)dimethacrylat > Bisphenol-A-ethoxylat(2)dimethacrylat.

Die in den erfindungsgemäßen Formulierungen als Komponente (b) eingesetzten Urethanmethacrylate mit einer Funktionalität < 4 sind dem Fachmann bekannt und können in bekannter Weise hergestellt werden, indem man beispielsweise ein hydroxylterminiertes Polyurethan mit Methacrylsäure zum entsprechendem Urethanmethacrylat umsetzt, oder indem man ein isocyanatterminiertes Präpolymer mit Hydroxymethacrylaten umsetzt. Entsprechende Verfahren sind z. B. aus EP 0579503 bekannt. Urethanmethacrylate sind auch im Handel erhältlich und werden beispielsweise unter der Bezeichnung PC-Cure® von der Firma Piccadilly Chemicals, unter der Produktbezeichnung CN 1963 von der Firma Sartomer und unter der Bezeichnung Genomer® von der Firma Rahn vertrieben.

Bevorzugt werden als Urethanmethacrylate solche eingesetzt, die mit einer Funktionalität von n < 4 und aus aliphatischen Edukten hergestellt worden sind, insbesondere das aus HEMA und TMDI erhaltene Isomerengemisch 7,7,9-(bzw.7,9,9-)Trimethyl-4,13-dioxo-3,14-dioxa-5,12-diazahexadecan-1,16-diol-dimethacrylat. Als Verbindungen der Komponente (c) können beispielsweise eingesetzt werden:1,3-Butandioldimethacrylat, 1,6-Hexandioldimethacrylat, 1,3-Butylenglykoldimethacrylat, Diethylenglykoldimethacrylat, Ethylenglykoldimethacrylat, Neopentyldimethacrylat, Polyethylenglykoldimethacrylat, Triethylenglykoldimethacrylat und Tetraethylenglykoldimethacrylat und bevorzugt 1,4-Butandioldimethacrylat. Solche Produkte sind im Handel erhältlich, beispielsweise von der Firma Sartomer.
In den erfindungsgemäßen Formulierungen können als Komponente (d) beispielsweise folgende Verbindungen enthalten sein: Allylmethacrylat, Methyl-, Ethyl-, n-Propyl-, n-Butyl-, Isobutyl-, n-Hexyl-, 2-Ethylhexyl-, n-Octyl-, n-Decyl-, n-Dodecyl-, Isobornyl-, Isodecyl-, Lauryl-, Stearylmethacrylat, 2-Hydroxyethyl-, 2- und 3-Hydroxypropylmethacrylat, Tetrahydrofurfurylmethacrylat und
Cyclohexylmethacrylat. Besonders bevorzugt ist dabei Ethylmethacrylat.

Als Komponente (e) können als Photoinitiatoren alle Typen eingesetzt werden, die bei der entsprechenden Bestrahlung freie Radikale bilden. Dabei sind bekannte Photoinitiatoren Verbindungen der Benzoine, Benzoinether, wie Benzoin, Benzoinmethylether, Benzoinethylether und Benzoinisopropylether, Benzoinphenylether und Benzoinacetat, Acetophenone, wie Acetophenon, 2,2-Dimethoxyacetophenon, und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert.-Butylanthrachinon, 1-Chloranthrachinon und 2-Amylanthrachinon, Triphenylphosphin, Benzoylphosphinoxide, wie beispielsweise 2,4,6-Trimethylbenzoyldiphenylphosphinoxid (Luzirin TPO) und Bis(2,4,6-trimethylbenzoylphenyl)-phosphinoxid, Benzophenone, wie Benzophenon und 4, 4'-Bis-(N,N'-dimethylamino) -benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton. Besonders bevorzugte Verbindungen, die in Kombination mit einem Nd:YVO₄-Festkörperlaser eingesetzt werden, sind Bis(2,4,6-trimethylbenzoyl)-phenylphosphinoxid, 2,4,6-Trimethylbenzoyldiphenylphosphinoxid, 2-Hydroxy-2-methylpropiophenon, Hydroxycyclohexylphenylketon und Mischungen dieser Photoinitiatoren.

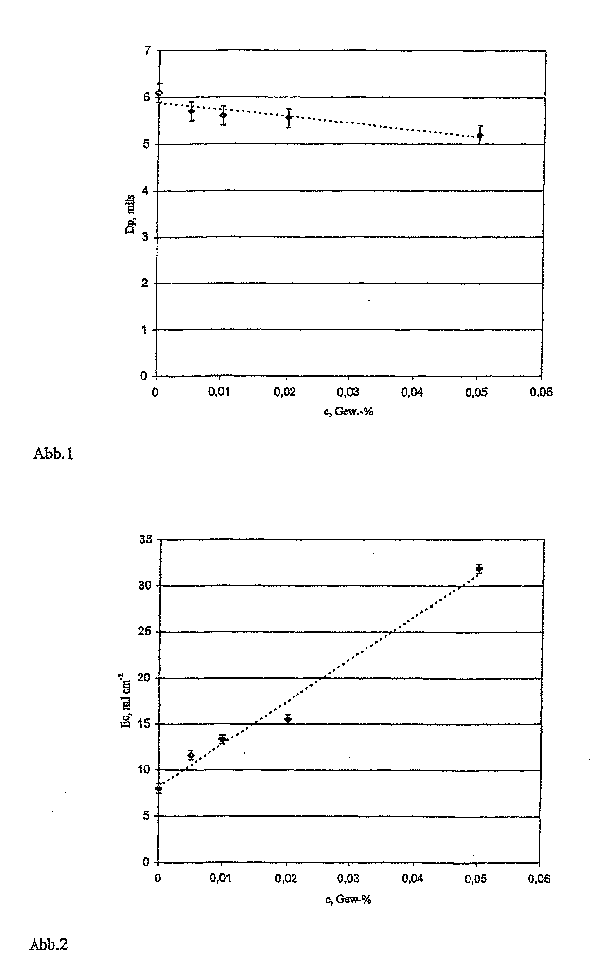

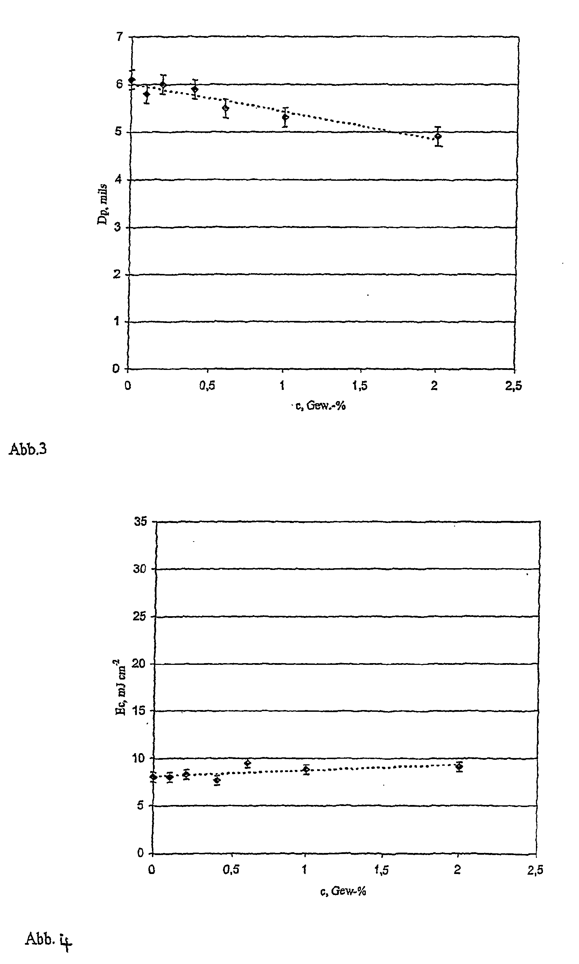

In den erfindungsgemäßen Gemischen wird als Inhibitor bzw. Stabilisator 2,2,6,6-Tetramethylpiperidin-1-yloxy (freies Radikal) zugesetzt. Der Einfluss der Konzentration an 2,2,6,6-Tetramethylpiperidin-1-yloxy (freies Radikal) in den Beispielformulierungen 1 auf die Eindringtiefe des Laserstrahls und die kritische Energie ist in den Abb. 1 und 2 dargestellt. Die Lasereindringtiefe und die kritischen Energie wurde mittels der Windowpane-Methode, beschrieben von P. F. Jacobs und D. T. Reid in Rapid Prototyping & Manufacturing, Society of Manufacturing Engineers, Dearborn, MI, 1992, 1st. ed., S. 263-280, bestimmt. Man kann den Abbildungen entnehmen, dass schon geringe Zugaben an 2,2,6,6-Tetramethylpiperidin-1-yloxy (freies Radikal) zu einem starken Anstieg der kritischen Energie bei nur geringer Veränderung der Eindringtiefe des Laserstrahles führen. Dieser Einfluss des Inhibitors 2,2,6,6-Tetramethylpiperidin-1-yloxy (freies Radikal) auf die relevanten Parameter Ec (kritische Energie, mJ cm⁻²) und Dp (Lasereindringtiefe, mils) des Stereolithographieharzes unterscheiden sich vom Einfluss der Inhibitoren wie z. B. Hydrochinon-monomethylether, die denen dem Stand der Technik entsprechenden Stereolithographieharzen zugefügt sind. Der Einfluss des Hydrochinon-monomethylether auf die Parameter Ec und Dp in den Beispielformulierungen 2 ist in Abb.3 und 4 dargestellt. Im Vergleich zum Einfluss des Inhibitors 2,2,6,6-Tetramethylpiperidin-1-yloxy (freies Radikal) kann die kritische Energie des Stereolithographieharzes nur durch wesentlich höhere Konzentrationen an Hydrochinon-monomethylether in einem signifikant geringerem Rahmen eingestellt werden. Darüber hinaus ist der Einfluss des Inhibitors Hydrochinon-monomethylether auf die Lasereindringtiefe größer als im Falle des Einsatzes von 2,2,6,6-Tetramethylpiperidin-1-yloxy (freies Radikal). Dies ist besonders von Nachteil, wenn die Parameter farbiger oder opaker Stereolithographieharze eingestellt werden müssen, da durch Zugabe von Pigmenten bzw. Farbstoffen die Lasereindringtiefe ebenfalls erniedrigt wird. Entsprechend der o. g. Ausführungen kann es so zu einer unter produktionstechnischen Gesichtspunkten unerwünschten Verlängerung der Bauzeiten der Formkörper kommen. Im Falle von Stereolithographieharzen aus dem Bereich der Medizintechnik, und insbesondere im Falle von Stereolithographieharzen für die Herstellung von Ohrstücken sind farbige bzw. opake Stereolithographieharzformulierungen jedoch von besonderer Relevanz.

### Beispiel 1:

| | |
|---|---|
| 70,3-x Gew.-% | Bisphenol-A-ethoxylat(4)dimethacrylat |
| 14,4 Gew.-% | Bisphenol-A-ethoxylat(2)dimethacrylat 9,2 Gew.-% 7,7,9-(bzw.7,9,9-)Trimethyl-4,13-dioxo-3,14-dioxa-5,12diaza-hexadecan-1,16-diol-dimethacrylat |
| 4,6 Gew.-% | 1,4-Butandioldimethacrylat |
| 1,5 Gew.-% | Bis(2,4,6-trimethylbenzoyl)-phenylphosphinoxid |
| x Ges.-% | 2,2,6,6-Tetramethylpiperidin-1-yloxy (freies Radikal) |

Das 2,2,6,6-Tetramethylpiperidin-1-yloxy (freies Radikal) wurde in den Konzentrationen von x= 0; 0,005; 0,01; 0,02 und 0,05 Gew.-% eingesetzt.

### Beispiel 2:

| | |
|---|---|
| 70,3-x Ges.-% | Bisphenol-A-ethoxylat(4)dimethacrylat |
| 14,4 Gew.-% | Bisphenol-A-ethoxylat(2)dimethacrylat |
| 9,2 Gew.-% | 7,7,9-(bzw.7,9,9-)Trimethyl-4,13-dioxo-3,14-dioxa-5,12diaza-hexadecan-1,16-diol-dimethacrylat |
| 4,6 Gew.-% | 1,4-Butandioldimethacrylat |
| 1,5 Gew.-% | Bis(2,4,6-trimethylbenzoyl) phenylphosphinoxid x Gew.-%Hydrochinon-monomethylether |

Der Inhibitor Hydrochinon-monomethylether wurde in den Konzentrationen von x= 0; 0,1; 0,2; 0,4; 0,6; 1 und
2 Gew.-% eingesetzt.

Es zeigt: Abb. 1:
Den Einfluss der Konzentration von 2,2,6,6-Tetramethylpiperidin-1-yloxy auf die Lasereindringtiefe Dp der Harzformulierung nach Beispiel 1.

### Abb. 2:

Den Einfluss der Konzentration von 2,2,6,6 Tetramethylpiperidin-1-yloxy auf die kritische Energie der Harzformulierungen aus Beispiel 1.

### Abb.3:

Den Einfluss der Konzentration von Hydrochinon-monomethylether auf die Lasereindringtiefe Dp der Harzformulierungen aus Bsp.2.

### Abb. 4

Den Einfluss der Konzentration von Hydrochinon-monomethylether auf die kritische Energie der Harzformulierungen aus Bsp. 2.

Den erfindungsgemäßen Gemischen können, falls erforderlich, die dem Fachmann bekannten Additive zugesetzt werden, beispielsweise Verlaufsmittel, UV-Stabilisatoren, Benetzungsmittel, Füllstoffe, Farbstoffe und Pigmente. Im Sinne der Erfindung besonders geeignete Farbstoffe sind AnthrachinonFarbstoff-Zubereitungen, wie sie z. B. von der Firma Bayer unter dem Namen Macrolex verkauft werden.

### Verwendungsbeispiele

### Beispiel 3 eines gelblich opaken Stereolithographieharzes:

| | |
|---|---|
| 66,69 Gew.-% | Bisphenol-A-ethoxylat(4)dimethacrylat |
| 15,6 Gew.-% | Bisphenol-A-ethoxylat(2)dimethacrylat |
| 10 Gew.-% | 7,7,9-(bzw.7,9,9-)Trimethyl-4,13-dioxo-3,14-dioxa-5,12-diaza-hexadecan-1,16-diol-dimethacrylat |
| 5 Gew.-% | 1,4-Butandioldimethacrylat |
| 1,5 Gew.-% | Bis(2,4,6-trimethylbenzoyl)-phenylphosphinoxid |
| 0,8 Gew.-% | pyrogene Kieselsäure |
| 0,4 Gew.-% | Eisenoxidpigment |
| 0,01 Gew.-% | 2,2,6,6-Tetramethylpiperidin-1-yloxy (freies Radikal) |

### Beispiel 4 eines blautransparenten Stereolithographieharzes:

| | |
|---|---|
| 69,035 Gew.-% | Bisphenol-A-ethoxylat(4)dimethacrylat |
| 15,6 Gew.-% | Bisphenol-A-ethoxylat(2)dimethacrylat |
| 10 Gew.-% | 7,7,9-(bzw.7,9,9-)Trimethyl-4,13-dioxo-3,14-dioxa-5,12-diaza-hexadecan-1,16-diol-dimethacrylat |
| 3,8 Gew.-% | 1,4-Butandioldimethacrylat |
| 1,5 Gew.-% | Bis(2,4,6-trimethylbenzoyl)-phenylphosphinoxid |
| 0,03 Gew.-% | Anthrachinon-Farbstoff-Zubereitung (enthält C.I. Solvent Blue 97) |
| 0,025 Gew.-% | UV-Stabilisator |
| 0,01 Gew.-% | 2,2,6,6-Tetramethylpiperidin-1-yloxy (freies Radikal) |

### Beispiel 5 eines rottransparenten Stereolithographieharzes:

| | |
|---|---|
| 69,055 Gew.-% | Bisphenol-A- ethoxylat(4)dimethacrylat |
| 15,6 Gew.-% | Bisphenol-A-ethoxylat(2)dimethacrylat |
| 10 Gew.-% | 7,7,9-(bzw.7,9,9-)Trimethyl-4,13-dioxo-3,14-dioxa-5,12-diaza-hexadecan-1,16-diol-dimethacrylat |
| 3,8 Gew.-% | 1,4-Butandioldimethacrylat |
| 1,5 Gew.-% | Bis(2,4,6-trimethylbenzoyl)-phenylphosphinoxid |
| 0,025 Gew.-% | UV-Stabilisator |
| 0,01 Gew.-% | Azofarbstoff Rot H |
| 0,01 Gew.-% | 2,2,6,6-Tetramethylpiperidin-1-yloxy (freies Radikal) |

Die für die Technik der Stereolithographie relevanten Parameter der o. g. Harze sind Viskosität, E- Modul, Biegefestigkeit, Dehnung, Ec- Werte und Dp- Werte.
Viskositätsmessungen wurden bei 23°C mit einem CVO 120-Rheometer der Fa. Bohlin Instruments durchgeführt. Die Bestimmung der Biegefestigkeiten,
E-Module und Dehnungen wurde in Anlehnung an die EN ISO 178 (1996) mit einer Zwick 1-Testmaschine der Fa. Zwick durchgeführt. Zur Ermittlung der Ec und Dp-Werte mittels der o. g. Windowpane-Methode wurden jeweils die Mittelwerte aus 10 Windowpane-Probekörpern ermittelt. Die Probekörper wurden mit einer Viper si² SLA Anlage, ausgerüstet mit einem Nd:YVO₄ Festkörperlaser, hergestellt. Die Grünlinge wurden mit der Stroboskop-Belichtungseinheit Sonolux PR der Fa. Innovation Meditech mittels 4000 Blitzen nachgehärtet.

Mit ausgehärteten Probekörpern der Stereolithographiharzformulierungen aus Bsp.3-5 wurden darüber hinaus Studien zum cytotoxischen, zum reizenden und zum allergisierenden bzw. sensibilisierenden Potential der Formulierungen durchgeführt.

Zur Bestimmung des reizenden Effektes wurden auf der Basis von ISO 10993-10 (2002), von ISO 10993-12 (2002) und von ISO 17025 (1999) Tests an weißen Neuseelandkaninchen durchgeführt. Diesen wurden Kontrolllösungen und Testextrakte aus den Probenkörpern intrakutan injiziert. Aus den Tests ergab sich, dass die o. g. Stereolithographieharzformulierungen vernachlässigbar reizend sind.

In einer weiteren Testreihe zur Bestimmung der biologischen Reaktion der Säugetierzellkultur (L929) auf die Probekörper wurden Elutionstests gemäß ISO 10993-5 (1999), ISO 10993-12 (2002) und ISO 17025 (1999) durchgeführt. Man findet keine biologische Reaktivität (Grad 0) der L929 Säugetierzellen. Dementsprechend sind die o. g. Materialien nicht cytotoxisch und genügen den Vorgaben aus ISO 10993-5. Ferner wurde das allergisierende Potential und die sensibilisierenden Eigenschaften der Probenkörper mittels einer Prüfreihe auf der Basis von ISO 10993-10 (2002), von ISO 10993-12 (2002) in Anlehnung an F. N. Marzulli und H. I. Maibach (eds.), 5^{th} ed., 1996, Seiten 403, 440-441, Hemisphere Publishing Corporation, New York, B. Magnusson und A. M. Kligman, J. Invest. Dermatol. 52:268-276 (1969), B. Magnusson und A. M. Kligman, 1970, Allergic contact dermatitis in the guinea pig. Identification of contact allergens, Springfield, IL.:Thomas evaluiert. Die o. g. Stereolithographieformulierungen induzierten keine biologische Reaktion (0 % Sensibilisierung). Gemäß der Skala nach Kligman handelt es sich dabei um eine Reaktion des Grades 1, so dass das allergisierende Potential der Stereolithographieformulierungen als schwach einzustufen ist. Eine Sensibilisierungsrate gemäß Grad 1 nach Magnusson und Kligman ist als nicht signifikant zu betrachten.
Aus diesen Ergebnissen wird deutlich, dass die erfindungsgemäßen Stereolithographieharzformulierungen im medizintechnischen Bereich, insbesondere für die Herstellung von Ohrstücken, einsetzbar sind.

Aus einem Vergleich mit den mechanischen und chemischen Parameter des kommerziell erhältlichen, opaken Stereolithographieharz LLS71410 der Fa. Vantico, welches für den medizintechnischen Einsatz konzipiert ist, kann man feststellen, dass im Vergleich die erfindungsgemäßen Formulierungen vorteilhafterweise wesentlich geringere Viskositäten und höhere Dp-Werte besitzen. Ferner liegen die mechanischen Eigenschaften Biegefestigkeit und E-Modul der offenbarten Formulierungen signifikant über den Werten für das kommerziell erhältliche Produkt. Darüber hinaus findet man, dass das Material der Fa. Vantico zwar als nicht cytotoxisch einzustufen ist, aber in Versuchsreihen zur Bestimmung der Cytotoxizität eine dem Grad 1 entsprechende, leichte biologische Reaktion induziert. Unter Berücksichtigung des Einsatzes im medizintechnischen Bereich ist dies bei den erfindungsgemäßen Formulierungen vorteilhafterweise nicht der Fall.

Alle erfindungsgemäßen Stereolithographieharzformulierungen aus den Bsp.3-5 weisen unter produktionstechnischen Gesichtspunkten ideale Viskositäten < 2250 mPa s und Grünfestigkeiten auf.
Die konventionelle Technik zur Herstellung von Ohrstücken basiert auf autopolymerisierenden bzw. lichthärtenden Materialien, die in eine Negativform eines Ohrabdruckes gegeben werden. Im Vergleich zu den in der konventionellen Technik genutzten Materialien zur Herstellung von Ohrstücken (z. B. Fotoplast® der Fa. Dreve Otoplastik GmbH) sind die mechanischen Werte Biegefestigkeit und E-Modul der ausgehärteten Formkörper signifikant höher.

## Patentansprüche

1. Biokompatible, niedrigviskose, strahlungshärtbare Formulierung , insbesondere für die Stereolithographie, zum Einsatz in der Medizintechnik, insbesondere zur Herstellung von Ohrstücken, enthaltend:
a) 55-95 Gew.-% eines monomeren oder oligomeren Dimethacrylats auf Basis von Bisphenol A oder Bisphenol F
b) 0-20 Gew.-% eines Urethanmethacrylats mit einer Funktionalität von n < 4 und einer Viskosität < 15 Pa s
c) 2-15 Ges.-% eines monomeren aliphatischen oder cycloaliphatischen Dimethacrylats mit einer Viskosität < 5 Pa s
d) 0-15 Gew.-% eines monofunktionellen Methacrylats mit einer Viskosität < 3 Pa s
e) 0,5-6 Gew.-% eines oder einer Kombination mehrere Photoinitiatoren, deren Absorption im Wellenlängenbereich des eingesetzten Laserstrahles liegt
f) 0,0001-2 Gew.-% des Inhibitors 2,2,6,6-Tetramethylpiperidin-1-yloxy (freies Radikal), auch in Verbindung mit bekannten Inhibitoren
g) 0-40 Gew.-% an Füllstoffen
h) 0-5 Ges.-% an Farbpigmenten
i) 0-5 Ges.-% an üblichen Additiven wie UV-Stabilisatoren oder Verlaufsadditiven, wobei der Anteil der Komponenten a) bis h) zusammen 100 Gew.-% beträgt.

2. Formulierung eines Gemisches nach Anspruch 1, enthaltend:
a) 60-90 Gew.-% eines n-fach ethoxylierten Bisphenol-A-Dimethacrylats mit einem Ethoxylierungsgrad von n < 10 oder eine Mischung n-fach ethoxylierter Bisphenol-A-Dimethacrylate mit einem Ethoxylierungsgrad von n < 10
b) 5-17 Gew.-% eines aliphatischen oder cycloaliphatischen Urethanmethacrylats mit einer Funktionalität von n < 4 und einer Viskosität < 10 Pa s
c) 3-10 Ges.-% eines monomeren aliphatischen oder cycloaliphatischen Dimethacrylats mit einer Viskosität < 3 Pa s
d) 2-10 Gew.-% eines monofunktionellen Methacrylats mit einer Viskosität < 3 Pa s
e) 1-4 Gew.-% eines oder einer Kombination mehrerer Photoinitiatoren, deren Absorption im Wellenlängenbereich des eingesetzten Laserstrahles liegt
f) 0,005-0,05 Gew.-% des Inhibitors 2,2,6,6-Tetramethylpiperidin-1-yloxy (freies Radikal), auch in Verbindung mit bekannten Inhibitoren
g) 0-20 Gew.-% an Füllstoffen
h) 0-5 Ges.-% an Farbpigmenten
i) 0,01-3 Gew.-% an üblichen Additiven wie UV-Stabilisatoren oder Verlaufsadditiven, wobei der Anteil der Komponenten a) bis h) zusammen 100 Gew.-% beträgt.

## Claims

1. Biocompatible, low-viscous, radiation-curable formulation, in particular for stereolithography, for use in medical technology, in particular for producing earpieces, containing:
a) 55-95% by weight of a monomeric or oligomeric dimethacrylate based on bisphenol A or bisphenol F
b) 0-20% by weight of a urethane methacrylate having a functionality of n < 4 and a viscosity < 15 Pa s
c) 2-15% by weight of a monomeric aliphatic or cycloaliphatic dimethacrylate having a viscosity < 5 Pa s
d) 0-15% by weight of a monofunctional methacrylate having a viscosity < 3 Pa s
e) 0.5-6% by weight of a photoinitiator or of a combination of a number of photoinitiators, the absorption of which is in the wavelength range of the laser beam used
f) 0.0001-2% by weight of the inhibitor 2,2,6,6-tetramethylpiperidin-1-yloxy (free radical), also in conjunction with known inhibitors
g) 0-40% by weight of fillers
h) 0-5% by weight of colour pigments
i) 0-5% by weight of customary additives such as UV stabilisers or flow additives, the proportion of components a) to h) together amounting to 100% by weight.

2. Formulation of a mixture according to claim 1, containing:
a) 60-90% by weight of an n-fold ethoxylated bisphenol A dimethacrylate having a degree of ethoxylation of n < 10 or a mixture of n-fold ethoxylated bisphenol A dimethacrylates having a degree of ethoxylation of n < 10
b) 5-17% by weight of an aliphatic or cycloaliphatic urethane methacrylate having a functionality of n < 4 and a viscosity < 10 Pa s
c) 3-10% by weight of a monomeric aliphatic or cycloaliphatic dimethacrylate having a viscosity < 3 Pa s
d) 2-10% by weight of a monofunctional methacrylate having a viscosity < 3 Pa s
e) 1-4% by weight of a photoinitiator or of a combination of a number of photoinitiators, the absorption of which is in the wavelength range of the laser beam used
f) 0.005-0.05% by weight of the inhibitor 2,2,6,6-tetramethylpiperidin-1-yloxy (free radical), also in conjunction with known inhibitors
g) 0-20% by weight of fillers
h) 0-5% by weight of colour pigments
i) 0.01-3% by weight of customary additives such as UV stabilisers or flow additives, the proportion of components a) to h) together amounting to 100% by weight.

## Revendications

1. Formulation radiodurcissable biocompatible à faible viscosité, en particulier pour la stéréolithographie, destinée à être utilisée dans la technique médicale, en particulier pour fabriquer des écouteurs ou des parties d'appareils auditifs, contenant :
a) 55 à 95 % en poids d'un diméthacrylate monomère ou oligomère à base de bisphénol A ou de bisphénol F,
b) 0 à 20 % en poids d'un méthacrylate d'uréthane ayant une fonctionnalité n < 4 et une viscosité < 15 Pa·s,
c) 2 à 15 % en poids d'un diméthacrylate monomère aliphatique ou cyclo-aliphatique ayant une viscosité < 5 Pa·s,
d) 0 à 15 % en poids d'un méthacrylate monofonctionnel ayant une viscosité < 3 Pa·s,
e) 0,5 à 6 % en poids d'un ou d'une combinaison de plusieurs photoamorceurs dont l'absorption se situe dans la plage de longueurs d'ondes du faisceau laser utilisé,
f) 0,0001 à 2 % en poids de l'inhibiteur 2,2,6,6-tétraméthylpipéridin-1-yloxy (radical libre), aussi associé à des inhibiteurs connus,
g) 0 à 40 % en poids de matières de charge,
h) 0 à 5 % en poids de pigments colorés,
i) 0 à 5 % en poids d'additifs usuels tels que des agents de stabilisation aux UV ou des additifs de nivelage, la somme des composants a) à h) étant égale à 100 % en poids.

2. Formulation d'un mélange selon la revendication 1, contenant :
a) 60 à 90 % en poids d'un diméthacrylate de bisphénol A éthoxylé n fois, ayant un degré d'éthoxylation n < 10, ou d'un mélange de diméthacrylates de bisphénol A éthoxylés n fois, ayant un degré d'éthoxylation n < 10,
b) 5 à 17 % en poids d'un méthacrylate d'uréthane aliphatique ou cyclo-aliphatique ayant une fonctionnalité n < 4 et une viscosité < 10 Pa·s,
c) 3 à 10 % en poids d'un diméthacrylate monomère aliphatique ou cyclo-aliphatique ayant une viscosité < 3 Pa·s,
d) 2 à 10 % en poids d'un méthacrylate monofonctionnel ayant une viscosité < 3 Pa·s,
e) 1 à 4 % en poids d'un ou d'une combinaison de plusieurs photoamorceurs dont l'absorption se situe dans la plage de longueurs d'ondes du faisceau laser utilisé,
f) 0,005 à 0,05% en poids de l'inhibiteur 2,2,6,6-tétraméthylpipéridin-1-yloxy (radical libre), aussi associé à des inhibiteurs connus,
g) 0 à 20 % en poids de matières de charge,
h) 0 à 5 % en poids de pigments colorés,
i) 0,01 à 3 % en poids d'additifs usuels tels que des agents de stabilisation aux UV ou des additifs de nivelage, la somme des composants a) à h) étant égale à 100 % en poids.
